# EUROPEAN PATENT SPECIFICATION

(11) **EP 0 396 104 B1**
(45) Date of publication and mention of the grant of the patent: **27.03.1996**
(21) Application number: 90108273.5
(22) Date of filing: 30.04.1990
(51) Int. Cl.: H01L 29/747, H03K 17/725

(54) **Bidirectional control rectifying semiconductor apparatus**
Halbleitergleichrichteranordnung mit bidirektionaler Kontrolle
Dispositif semi-conducteur redresseur à contrôle bidirectionnel

(30) Priority: 01.05.1989 JP 109050/89
(43) Date of publication of application: 07.11.1990
(60) Divisional application: 94115450.2
(73) Proprietor: KABUSHIKI KAISHA TOSHIBA, Kawasaki-shi, Kanagawa-ken 210, Tokyo (JP)
(72) Inventor: Miwa, Junichi, c/o Intellectual Property, 1-chome, Minato-ku, Tokyo 105 (JP); Asakura, Kouichi, c/o Intellectual Property, 1-chome, Minato-ku, Tokyo 105 (JP)
(74) Representative: Lehn, Werner, Dipl.-Ing.

(56) References cited:
- EP-A- 0 287 856
- DE-A- 3 120 254
- PATENT ABSTRACTS OF JAPAN, vol. 4, no. 148 (E-30)[630], 18th October 1980 & JP-A-55 99 773

## Description

The present invention relates to a bidirectional control rectifying semiconductor apparatus and, more particularly, to a bidirectional control rectifying semiconductor apparatus having a high gate sensitivity capable of driving an element by a small current.

EP-A-0 287 856 discloses such apparatus which comprises:
a first conductive layer of a first conductivity type;
second, third, and fourth conductive layers of a second conductivity type formed in one major surface region of said first conductive layer and separated from each other;
a fifth conductive layer of the first conductivity type formed in a surface region of said second conductive layer;
a sixth conductive layer of the first conductivity type formed in a surface region of said third conductive layer;
a seventh conductive layer of the first conductivity type formed in a surface region of said fourth conductive layer;
an eighth conductive layer of the second conductivity type formed on the other major surface region and side portions of said first conductive layer;
a ninth conductive layer of the first conductivity type formed in a surface region of said eighth conductive layer;
a first electrode overlapping said second and fifth conductive layers;
a second electrode arranged on said eighth and ninth conductive layers;
said second conductive layer and said third conductive layer being connected through a first wiring layer;
said second conductive layer and said seventh conductive layer being connected through a second wiring layer; and
said fourth conductive layer and said sixth conductive layer being connected through a third wiring layer to define a terminal of said third wiring layer as a gate electrode.
The use of capacitors to improve dv/dt withstand amount is discussed in DE-A- 31 20 254.

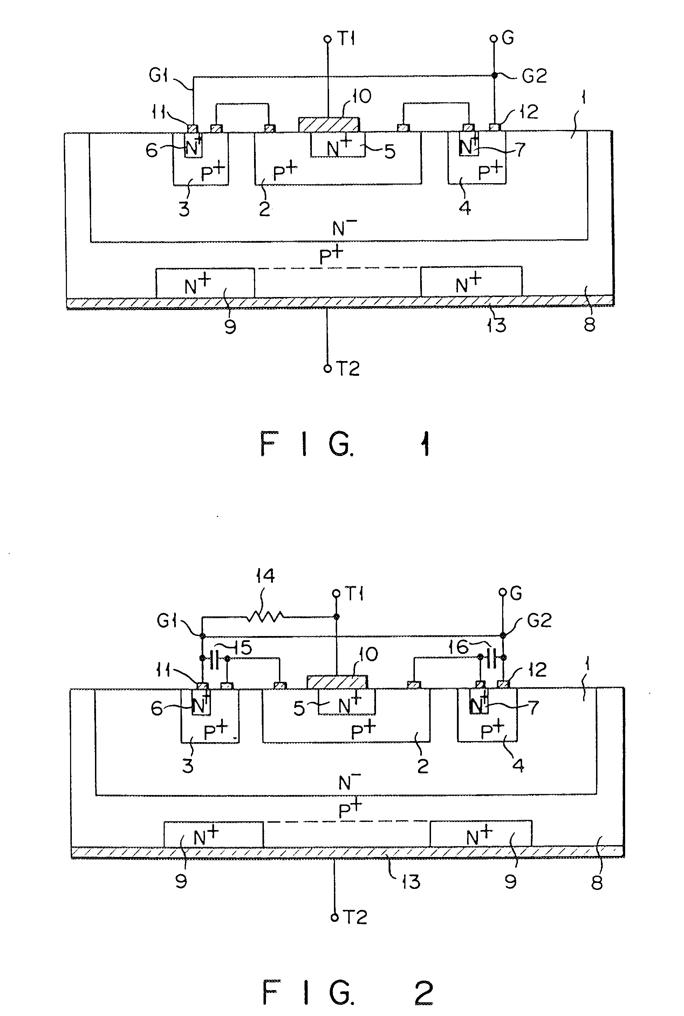

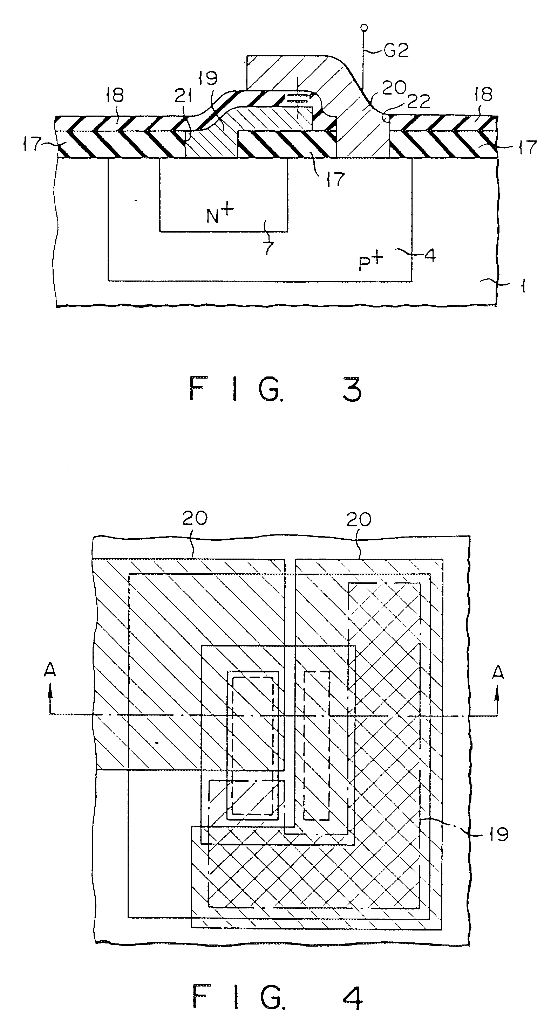

Fig. 1 shows a sectional view showing a TRIAC which is one type of bidirectional control rectifying semiconductor apparatus. That is, an eighth conductive layer 8 as a p⁺-type conductive layer is formed on the lower and side surfaces of a first conductive layer 1 serving as an n⁻-type substrate by a known technique. A ninth conductive layer 9 as an n⁺-type conductive layer is formed in the lower surface region of the eighth conductive layer 8. A second electrode 13 is arranged on the lower surface of the eighth conductive layer 8 and a terminal of the second electrode 13 is represented by T₂. As shown in Fig. 1, three p⁺-type conductive layers, i.e., second, third, and forth conductive layers 2, 3, and 4, are formed in the surface region of the first conductive layer 1. N⁺-type conductive layers, i.e., fifth, sixth, and seventh conductive layers 5, 6, and 7, are formed in the surface regions of the conductive layers 2, 3, and 4, respectively. A first electrode 10 is arranged on the surfaces of the fifth conductive layer 5 and the second conductive layer 2, and a terminal of the first electrode 10 is represented by T₁. The second and third conductive layers 2 and 3 and the second and seventh conductive layers 2 and 7 are connected through Aℓ wiring layers, respectively. First and second gate electrodes 11 and 12 are arranged on the sixth and fourth conductive layers 6 and 4, respectively. Terminals of the first and second gate electrodes 11 and 12 are represented by G₁ and G₂, respectively. The terminals G₁ and G₂ of the first and second gate electrodes 11 and 12 are connected to each other through an Aℓ wiring layer to obtain a common terminal G.

First, an operation principle of the conventional TRIAC will be described. There are four modes I, II, III, and IV for turning on the TRIAC having such an arrangement. In the mode I (T₂+, G+), the TRIAC performs the same operation as in a conventional amplifying gate thyristor. In the mode II (T₂+, G-), the terminal G₁ section of the first gate electrode 11 performs a negative bias junction thyristor operation. In the mode III (T₂-, G-), the terminal G₁ section of the first gate electrode 11 performs a remote gate operation. In the mode IV (T₂-, G+), the terminal G₂ section of the second gate electrode 12 performs the remote gate operation (the terminal T₁ section of the first electrode 10 secondarily performs the remote gate operation). Since a sub thyristor section of the conventional TRIAC, formed by the third and forth conductive layers 3 and 4 and the sixth and seventh conductive layers 6 and 7, has a non-shorted structure, a resistor is arranged outside the TRIAC between the terminal T₁ of the first electrode 10 and the common terminal G of the first and second gate electrodes 11 and 12 to adjust a resistance R_{GK}, and an emitter junction in the sub thyristor section is made shallow to reduce a gate sensitivity and improve a dv/dt withstand amount. The dv/dt withstand amount is a dv/dt value corresponding to an ignition error of a thyristor when an abruptly leading voltage is applied to a gate of the thyristor and a displacement current flows into a base section of the thyristor.

In the conventional TRIAC, a main thyristor section is undesirably turned on by an erroneous operation of the sub thyristor section caused by the abruptly leading voltage. In a practical application, the dv/dt withstand amount is improved by arranging external resistors or capacitors.

The present invention has been made in consideration of the above situation, and has as its cbject to provide a TRIAC, wherein a dv/dt withstand amount is improved by incorporating a capacitor in a sub thyristor section of the TRIAC, whilst avoiding additional manufacturing steps.

A bidirectional control rectifying semiconductor apparatus according to the present invention comprises:
a first conductive layer of a first conductivity type;
second, third, and fourth conductive layers of a second conductivity type formed in one major surface region of the first conductive layer and separated from each other;
a fifth conductive layer of the first conductivity type formed in a surface region of the second conductive layer;
a sixth conductive layer of the first conductivity type formed in a surface region of the third conductive layer;
a seventh conductive layer of the first conductivity type formed in a surface region of the fourth conductive layer;
an eighth conductive layer of the second conductivity type formed on the other major surface region and side portions of the first conductive layer;
a ninth conductive layer of the first conductivity type formed in a surface region of the eighth conductive layer;
a first electrode overlapping the second and fifth conductive layers;
a second electrode arranged on the eight and ninth conductive layers;
said second conductive layer and said third conductive layer being connected through a first wiring layer;
said second conductive layer and said seventh conductive layer being connected through a second wiring layer; and
said fourth conductive layer and said sixth conductive layer being connected through a third wiring layer to define a terminal of said third wiring layer as a gate electrode;
characterised in that:
a first oxide film is formed on the surface of said first conductive layer;
a second oxide film is formed on the surface of said first oxide film;
a first capacitor is connected between said third conductive layer and said sixth conductive layer; and
a second capacitor is connected between said fourth conductive layer and said seventh conductive layer, said second capacitor consists of overlapping portions of a tenth conductive layer formed between said first and second oxide layers and of a second gate electrode formed on said second oxide layer, said tenth conductive layer being connected to said seventh conductive layer and said second gate electrode being connected to said fourth conductive layer.

This invention can be more fully understood from the following detailed description when taken in conjunction with the accompanying drawings, in which:
Fig. 1 is a sectional view showing a TRIAC which is one type of bi-directional control rectifying semiconductor apparatus;
Fig. 2 is a schematic view showing a TRIAC employing a bidirectional control rectifying semiconductor apparatus according to the present invention;
Fig. 3 is a TRIAC in which a second capacitor shown in Fig. 2 is practically incorporated as a wafer device;
Fig. 4 is a planar pattern capable of incorporating the second capacitor shown in Fig. 3; and
Fig. 5 is a sectional view showing the pattern along the line A-A in Fig. 4

An embodiment of the present invention will be described in detail with reference to the accompanying drawings. As shown in Fig. 2, an eighth conductive layer 8 as a p⁺-type conductive layer is formed on the lower and side surfaces of a first conductive layer 1 serving as an n⁻-type substrate by a known technique. A ninth conductive layer 9 as an n⁺-type conductive layer is formed in the lower surface region of the eighth conductive layer 8. A second electrode 13 is arranged on the lower surface of the eighth conductive layer 8 and a terminal of the second electrode 13 is represented by T₂. As shown in Fig. 2, three p⁺-type conductive layers, i.e., second, third, and fourth conductive layers 2, 3, and 4, are formed in the surface region of the first conductive layer 1. N⁺-type conductive layers, i.e., fifth, sixth, and seventh conductive layers 5, 6, and 7, are formed in the surface regions of the conductive layers 2, 3, and 4, respectively. A first electrode 10 is arranged on the surfaces of the second conductive layer 2 and the fifth conductive layer 5, and a terminal of the first electrode 10 is represented by T₁. The second and third conductive layers 2 and 3 and the second and seventh conductive layers 2 and 7 are connected through Aℓ wiring layers, respectively.

First and second gate electrodes 11 and 12 are arranged on the sixth and fourth conductive layers 6 and 4, respectively. Terminals of the first and second gate electrodes 11 and 12 are represented by G₁ and G₂, respectively. The terminals G₁ and G₂ are connected to each other through an Aℓ wiring layer to define a common terminal of the terminals G₁ and G₂ as an electrode G. The first and second gate electrodes 11 and 12 are connected to the first electrode through a resistor 14 consisting of polysilicon or the like formed on the surface of the first conductive layer 1. A first capacitor 15 is arranged between the third conductive layer 3 and the first gate electrode 11. A second capacitor 16 is arranged between the seventh conductive layer 7 and the second gate electrode 12.

Fig. 2 is a schematic view showing a TRIAC employing a bidirectional control rectifying semiconductor apparatus according to the present invention. Fig. 3 shows a TRIAC in which the second capacitor 16 shown in Fig. 2 is practically incorporated as a wafer device.

In Fig. 3, a first oxide film 17 is formed on the surface of a first conductive layer 1. First and second contact holes 21 and 22 are formed in the first oxide film 17. A second oxide film 18 is formed on the first oxide film 17. Reference numeral 19 denotes a polysilicon layer which is formed between the first and second oxide films 17 and 18 and one end of which is in contact with a seventh conductive layer 7 through the first contact hole 21.

Reference numeral 20 denotes an aluminum layer which is formed on the second oxide layer 18 one end of which is in contact with a fourth conductive layer 4 through the second contact hole 22 formed in the first and second oxide films 17 and 18, and the other end of which extends the polysilicon layer 19. The aluminum over layer 20 serves as a second gate electrode G₂.

A second capacitor 16 is formed by the second oxide film 18 and the polysilicon layer 19.

Fig. 4 shows a planar pattern capable of incorporating a second capacitor 16 in a TRIAC without increasing a chip area when the second capacitor 16 is arranged between a seventh conductive layer 7 and a second gate electrode 12.

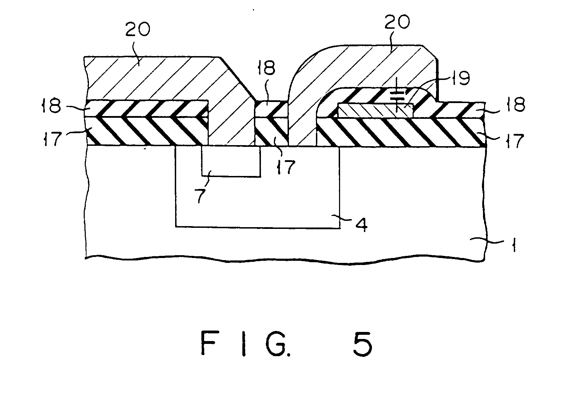

Fig. 5 is a sectional view showing the pattern along the line A - A in Fig. 4.

By employing the arrangement shown in Figs. 4 and 5, a capacitor can be formed under a gate electrode. Therefore, the capacitor can be incorporated in a TRIAC without increasing a chip area.

The same reference numerals as in Fig. 3 denote the same or corresponding parts in Figs. 4 and 5.

By incorporating a capacitor in the sub thyristor section of the TRIAC, the same effect as an increase in junction capacity of a G-K path of the sub thyristor section (e.g., between the sixth and seventh conductive layers) can be obtained, and a dv/dt withstand amount is increased. For example, when a resistor having a resistance R_{GK} of about 1 kΩ, and a capacitor having a capacitance of 100 to 1,000 pF are incorporated in the sub thyristor section, the dv/dt withstand amount is improved by 50 V/µs or more in comparison with a TRIAC without an incorporated capacitor.

Reference signs in the claims are intended for better understanding and shall not limit the scope.

## Claims

1. A bi-directional control rectifying semiconductor apparatus comprising:
a first conductive layer (1) of a first conductivity type;
second, third and fourth conductive layers (2,3,4) of a second conductivity type formed in one major surface region of said first conductive layer (1) and separated from each other;
a fifth conductive layer (5) of the first conductivity type formed in a surface region of said second conductive layer (2);
a sixth conductive layer (6) of the first conductivity type formed in a surface region of said third conductive layer (3);
a seventh conductive layer (7) of the first conductivity type formed in a surface region of said fourth conductive layer (4);
an eighth conductive layer (8) of the second conductivity type formed on the other major surface region and side portions of said first conductive (1) layer;
a ninth conductive layer (9) of the first conductivity type formed in a surface region of said eight conductive layer (8);
a first electrode (10) overlapping said second and fifth conductive layers (2,5);
a second electrode (13) arranged on said eighth and ninth conductive layers (8,9);
said second conductive layer (2) and said third conductive layer (3) being connected through a first wiring layer;
said second conductive layer (2) and said seventh conductive layer (7) being connected through a second wiring layer; and
said fourth conductive layer (4) and said sixth conductive layer (6) being connected through a third wiring layer to define a terminal of said third wiring layer as a gate electrode (G)
characterised in that:
a first oxide film (17) is formed on the surface of said first conductive layer (1);
a second oxide film (18) is formed on the surface of said first oxide film (17);
a first capacitor (15) is connected between said third conductive layer (3) and said sixth conductive layer (6); and
a second capacitor (16) is connected between said fourth conductive layer (4) and said seventh conductive layer (7), said second capacitor consists of overlapping portions of a tenth conductive layer (19) formed between said first and second oxide layers and of a second gate electrode (20) formed on said second oxide layer, said tenth conductive layer being connected to said seventh conductive layer (7) and said second gate electrode (20) being connected to said fourth conductive layer (4).

2. An apparatus according to claim 1, characterised in that a resistor (14) is arranged between said first electrode (T₁) and said gate electrode (G).

## Patentansprüche

1. Halbleitergleichrichtereinrichtung mit bidirektionaler Steuerung, umfassend:
eine erste leitende Schicht (1) eines ersten Leitfähigkeits-Typs;
eine zweite, eine dritte und eine vierte leitende Schicht (2, 3, 4) eines zweiten Leitfähigkeits-Typs, die in einem Hauptoberflächenbereich der ersten leitenden Schicht (1) gebildet und voneinander getrennt sind;
eine fünfte leitende Schicht (5) des ersten Leitfähigkeits-Typs, die in einem Oberflächenbereich der zweiten leitenden Schicht (2) gebildet ist;
eine sechste leitende Schicht (6) des ersten Leitfähigkeits-Typs, die in einem Oberflächenbereich der dritten leitenden Schicht (3) gebildet ist;
eine siebte leitende Schicht (7) des ersten Leitfähigkeits-Typs, die in einem Oberflächenbereich der vierten leitenden Schicht (4) gebildet ist;
eine achte leitende Schicht (8) des zweiten Leitfähigkeits-Typs, die auf dem anderen Hauptoberflächenbereich und Seitenabschnitten der ersten leitenden (1) Schicht gebildet ist;
eine neunte leitende Schicht (9) des ersten Leitfähigkeits-Typs, die in einem Oberflächenbereich der achten leitenden Schicht (8) gebildet ist;
eine erste Elektrode (10), die die zweite und fünfte leitende Schicht (2, 5) überlappt;
eine sechste Elektrode (13), die auf der achten und neunten leitenden Schicht (8, 9) angeordnet ist;
wobei die zweite leitende Schicht (2) und die dritte leitende Schicht (3) durch eine erste Verdrahtungsschicht verbunden sind;
wobei die zweite leitende Schicht (2) und die siebte leitende Schicht (7) durch eine zweite Verdrahtungsschicht verbunden sind; und
wobei die vierte leitende Schicht (4) und die sechste leitende Schicht (6) durch eine dritte Verdrahtungsschicht verbunden sind, um einen Anschluß der dritten Verdrahtungsschicht als eine Gate-Elektrode (G) zu definieren;
dadurch gekennzeichnet, daß:
ein erster Oxidfilm (17) auf der Oberfläche der ersten leitenden Schicht (1) gebildet ist;
ein zweiter Oxidfilm (18) auf der Oberfläche des ersten Oxidfilms (17) gebildet ist;
ein erster Kondensator (15) zwischen die dritte leitende Schicht (3) und die sechste leitende Schicht (6) geschaltet ist; und
ein zweiter Kondensator (16) zwischen die vierte leitende Schicht (4) und die siebte leitende Schicht (7) geschaltet ist, wobei der zweite Kondensator besteht aus überlappenden Abschnitten einer zehnten leitenden Schicht (19), die zwischen der dritten und zweiten Oxidschicht gebildet ist, und aus einer zweiten Gate-Elektrode (20), die auf der zweiten Oxidschicht gebildet ist, wobei die zehnte leitende Schicht mit der siebten leitenden Schicht (7) verbunden ist und die zweite Gate-Elektrode (20) mit der vierten leitenden Schicht (4) verbunden ist.

2. Einrichtung nach Anspruch 1, dadurch gekennzeichnet, daß ein Widerstand (14) zwischen der ersten Elektrode (T₁) und der Gate-Elektrode (G) angeordnet ist.

## Revendications

1. Dispositif semi-conducteur redresseur à contrôle bidirectionnel comprenant :
une première couche conductrice (1) d'un premier type de conductivité ;
des seconde, troisième et quatrième couches conductrices (2, 3, 4) d'un second type de conductivité formées dans une zone de surface principale de ladite première couche conductrice (1) et séparées les unes des autres ;
une cinquième couche conductrice (5) du premier type de conductivité formée dans une zone de surface de ladite seconde couche conductrice (2) ;
une sixième couche conductrice (6) du premier type de conductivité formée dans une zone de surface de ladite troisième couche conductrice (3) ;
une septième couche conductrice (7) du premier type de conductivité formée dans une zone de surface de ladite quatrième couche conductrice (4) ;
une huitième couche conductrice (8) du second type de conductivité formée sur l'autre zone de surface principale et des parties latérales de ladite première couche conductrice (1) ;
une neuvième couche conductrice (9) d'un premier type de conductivité formée dans une zone de surface de ladite huitième couche conductrice (8) ;
une première électrode (10) chevauchant lesdites seconde et cinquième couches conductrices (2, 5) ;
une seconde électrode (13) disposée sur lesdites huitième et neuvième couches conductrices (8, 9) ;
ladite seconde couche conductrice (2) et ladite troisième couche conductrice (3) étant reliées via une première couche de câblage ;
ladite seconde couche conductrice (2) et ladite septième couche conductrice (7) étant reliées via une seconde couche de câblage ; et
ladite quatrième couche conductrice (4) et ladite sixième couche conductrice (6) étant reliées via une troisième couche de câblage pour définir une borne de ladite troisième couche de câblage comme une électrode de grille (G)
caractérisé en ce que
une première couche d'oxyde (17) est formée sur la surface de ladite première couche conductrice (1) ;
une seconde couche d'oxyde (18) est formée sur la surface de ladite première couche d'oxyde (17) ;
un premier condensateur (15) est relié entre ladite troisième couche conductrice (3) et ladite sixième couche conductrice (6) ; et
un second condensateur (16) est relié entre ladite quatrième couche conductrice (4) et ladite septième couche conductrice (7), ledit second condensateur se compose des parties chevauchant une dixième couche conductrice (19) formée entre lesdites première et seconde couches d'oxyde et d'une seconde électrode de grille (20) formée sur ladite seconde couche d'oxyde, ladite dixième couche conductrice étant reliée à ladite septième couche conductrice (7) et ladite seconde électrode de grille (20) étant reliée à ladite quatrième couche conductrice (4).

2. dispositif selon la revendication 1 caractérisé en ce qu'une résistance (14) est disposée entre ladite première électrode (T₁) et ladite électrode de grille (G).
